# EUROPEAN PATENT APPLICATION

(11) **EP 4 742 852 A1**
(43) Date of publication of application: **13.05.2026**
(21) Application number: 25199737.5
(22) Date of filing: 02.09.2025
(51) Int. Cl.: H10D 30/01, H10D 30/66, H10D 62/832, H10D 64/01

(54) **SILICON CARBIDE METAL-OXIDE-SEMICONDUCTOR FIELD-EFFECT TRANSISTOR AND MANUFACTURING METHOD THEREOF**

(30) Priority: 08.11.2024 TW 113142945
(71) Applicant: ProAsia Semiconductor Corporation, Hsinchu 30078 (TW)
(72) Inventor: WANG, Pei-Jen, 30078 Hsinchu (TW); HUANG, Pin-Yen, 30078 Hsinchu (TW)
(74) Representative: Michalski Hüttermann & Partner Patentanwälte mbB

(57) **Abstract**

The invention provides a method for manufacturing a silicon carbide metal-oxide-semiconductor field-effect transistor, which includes the following steps: providing a SiC substrate; forming an N-type SiC epitaxial layer with a top surface on the SiC substrate; forming two doped structures in the N-type SiC epitaxial layer adjacent to the top surface, wherein each doped structure includes a P-type well, an N+ doped region, and a P+ doped region, the N+ doped region is located in the P-type well, and the P+ doped region is located in the P-type well and adjacent to the N+ doped region; depositing a silicon-rich nitride film on the top surface; depositing a gate oxide layer on the silicon-rich nitride film, wherein the gate oxide layer and the N-type SiC epitaxial layer are insulated by the silicon-rich nitride film; performing a post-oxidation annealing process for the gate oxide layer; and forming a gate structure on the gate oxide layer.

## Description

### CROSS-REFERENCES TO RELATED APPLICATIONS

This application claims the benefit of priority to Taiwanese Patent Application No. 113142945 filed on November 8, 2024, which is hereby incorporated by reference in its entirety.

### BACKGROUND OF THE INVENTION

### Field of the Invention

The present invention relates to a silicon carbide metal-oxide-semiconductor field-effect transistor and a method for manufacturing the same, and more particularly to a silicon carbide metal-oxide-semiconductor field-effect transistor and a method for manufacturing the same that improve interface quality to enhance channel mobility.

### Descriptions of the Related Art

Silicon carbide metal-oxide-semiconductor field-effect transistors (SiC MOSFETs) possess characteristics such as high temperature resistance, high voltage tolerance, and low on-resistance, making them suitable for high-speed power devices. They can provide higher electron mobility and faster switching speeds. However, the interface between the silicon carbide substrate and the gate oxide layer in SiC MOSFETs tends to generate oxygen vacancy defects, which increase the interface trap density. This causes electrons to be trapped while flowing through the interface, resulting in reduced channel mobility and increased channel resistance. Since channel resistance constitutes a large portion of the on-resistance, an increase in channel resistance will also lead to an increase in on-resistance, causing greater device power loss and potentially severe reliability issues.

Therefore, how to design a silicon carbide metal-oxide-semiconductor field-effect transistor and a manufacturing method thereof that can improve the aforementioned problems is indeed a subject worthy of study.

### SUMMARY OF THE INVENTION

The objective of the present invention is to provide a method for manufacturing a silicon carbide metal-oxide-semiconductor field-effect transistor that improves interface quality to enhance channel mobility.

To achieve the aforementioned objective, the method for manufacturing a silicon carbide metal-oxide-semiconductor field-effect transistor according to the present invention comprises the steps of: providing a silicon carbide substrate; forming an N-type silicon carbide epitaxial layer on the silicon carbide substrate, wherein the N-type silicon carbide epitaxial layer includes a top surface; forming two doped structures in the N-type silicon carbide epitaxial layer adjacent to the top surface, wherein each of the doped structures includes a P-type well, an N+ doped region, and a P+ doped region, the N+ doped region is located in the P-type well, and the P+ doped region is located in the P-type well and adjacent to the N+ doped region; depositing a silicon-rich nitride film on the top surface; depositing a gate oxide layer on the silicon-rich nitride film, wherein the silicon-rich nitride film insulates the gate oxide layer from the N-type silicon carbide epitaxial layer; performing a post-oxidation annealing process for the gate oxide layer; and forming a gate structure on the gate oxide layer.

In one embodiment of the present invention, the thickness of the silicon-rich nitride film is between 50Å and 150Å.

In one embodiment of the present invention, the silicon-rich nitride film is deposited on the top surface by an atomic layer deposition process.

In one embodiment of the present invention, the post-oxidation annealing process is performed in an environment containing nitric oxide or nitrous oxide for high-temperature annealing.

In one embodiment of the present invention, the gate structure is made of polysilicon or metal.

The present invention further provides a silicon carbide metal-oxide-semiconductor field-effect transistor. The silicon carbide metal-oxide-semiconductor field-effect transistor of the present invention comprises a silicon carbide substrate, an N-type silicon carbide epitaxial layer, two doped structures, a silicon-rich nitride film, a gate oxide layer, and a gate structure. The N-type silicon carbide epitaxial layer includes a top surface. The two doped structures are formed in the N-type silicon carbide epitaxial layer adjacent to the top surface, wherein each of the doped structures includes a P-type well, an N+ doped region, and a P+ doped region, the N+ doped region is located in the P-type well, and the P+ doped region is located in the P-type well and adjacent to the N+ doped region. The silicon-rich nitride film is located on the top surface. The gate oxide layer is located on the silicon-rich nitride film, wherein the silicon-rich nitride film insulates the gate oxide layer from the N-type silicon carbide epitaxial layer. The gate structure is located on the gate oxide layer.

### BRIEF DESCRIPTION OF THE DRAWINGS

FIG. 1 is a schematic diagram of the structure of the silicon carbide metal-oxide-semiconductor field-effect transistor of the present invention.
FIG. 2 is a flowchart of the manufacturing method of the silicon carbide metal-oxide-semiconductor field-effect transistor of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application, or particular method for implementations described in these embodiments. Therefore, the description of these embodiments is for illustrative purposes only and is not intended to limit the present invention. Since the various aspects and embodiments described herein are merely illustrative and not limiting, those of ordinary skill in the art can devise other aspects and embodiments without departing from the scope of the present invention after reading this specification. The following detailed description and the claims will further highlight the features and advantages of these embodiments.

In this document, the terms "a" or "an" are used to describe elements and components for the convenience of explanation and to provide a general sense of the scope of the invention. Therefore, unless clearly indicated otherwise, such terminology should be understood to include one or more, and the singular also encompasses the plural.

As used herein, the terms "comprising," "including," or any other similar expressions are intended to denote non-exclusive inclusion. For example, a component or structure that comprises multiple elements is not limited to only those elements explicitly listed herein but may also include other elements inherent to such a component or structure.

In the following description, the silicon carbide metal-oxide-semiconductor field-effect transistor of the present invention is exemplified by an N-type MOSFET, and thus its internal structures are arranged accordingly to the N-type MOSFET. However, the present invention is not limited thereto; for example, the silicon carbide metal-oxide-semiconductor field-effect transistor of the present invention can also be designed as a P-type MOSFET, such that all related internal structures have conductivity types opposite to those of the N-type MOSFET.

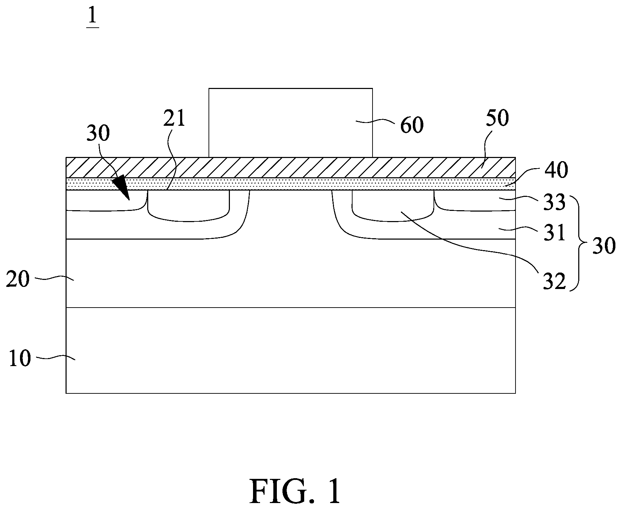

Referring to FIG. 1, which is a schematic structural diagram of the silicon carbide metal-oxide-semiconductor field-effect transistor of the present invention. As shown in FIG. 1, the silicon carbide metal-oxide-semiconductor field-effect transistor 1 of the present invention mainly includes a silicon carbide substrate 10, an N-type silicon carbide epitaxial layer 20, two doped structures 30, a silicon-rich nitride film 40, a gate oxide layer 50, and a gate structure 60. The silicon carbide substrate 10 and the N-type silicon carbide epitaxial layer 20 constitute the basic structural components of the silicon carbide metal-oxide-semiconductor field-effect transistor 1. The N-type silicon carbide epitaxial layer 20 is formed on the silicon carbide substrate 10 and includes a top surface 21. In one embodiment of the present invention, the silicon carbide substrate 10 is made of N-type silicon carbide material.

The two doped structures 30 are formed in the N-type silicon carbide epitaxial layer 20 and adjacent to the top surface 21, and the two doped structures 30 are arranged opposite to and spaced from each other. Each doped structure 30 includes a P-type well 31, an N-type (N⁺) doped region 32, and a P-type (P⁺) doped region 33. The P-type well 31 is adjacent to the top surface 21 and extends downward from the top surface 21, and the P-type well 31 has a conductivity type opposite to that of the N-type silicon carbide epitaxial layer 20. The N+ doped region 32 is located in the P-type well 31. The N+ doped region 32 is adjacent to the top surface 21 and extends downward from the top surface 21, and the N+ doped region 32 has the same conductivity type as the N-type silicon carbide epitaxial layer 20 and the silicon carbide substrate 10. The P+ doped region 33 is located in the P-type well 31. The P+ doped region 33 is respectively adjacent to the top surface 21 and the N+ doped region 32, and extends downward from the top surface 21, and the P+ doped region 33 has a conductivity type opposite to that of the N-type silicon carbide epitaxial layer 20 and the silicon carbide substrate 10.

The silicon-rich nitride film 40 is located on the top surface 21 and serves as an interfacial passivation layer. In one embodiment of the present invention, the silicon-rich nitride film 40 is formed by depositing silicon-rich nitride on the top surface 21 using an atomic layer deposition process. In one embodiment of the present invention, the thickness of the silicon-rich nitride film 40 is between 50Å and 150Å.

The gate oxide layer 50 is located on the silicon-rich nitride film 40, such that the gate oxide layer 50 is insulated from the N-type silicon carbide epitaxial layer 20 by the silicon-rich nitride film 40. The gate oxide layer 50, after being formed, requires a post-oxidation annealing process to reduce the interface state density. In one embodiment of the present invention, the gate oxide layer 50 is made of silicon dioxide (SiO₂).

The gate structure 60 is located on the gate oxide layer 50. In one embodiment of the present invention, the gate structure 60 is made of polysilicon; however, the present invention is not limited thereto, and the gate structure 60 may also be made of a metal material, for example.

In conventional silicon carbide metal-oxide-semiconductor field-effect transistors, the gate oxide layer is formed directly on the N-type silicon carbide epitaxial layer, allowing carbon atoms in the N-type silicon carbide epitaxial layer to readily diffuse into the gate oxide layer and react with oxygen atoms therein, thereby generating carbon by-products and increasing the number of interface defects. In contrast, in the silicon carbide metal-oxide-semiconductor field-effect transistor 1 of the present invention, the gate oxide layer 50 is insulated from the N-type silicon carbide epitaxial layer 20 by the silicon-rich nitride film 40. As a result, the carbon atoms in the N-type silicon carbide epitaxial layer 20 are inhibited by the silicon-rich nitride film 40 and are less likely to diffuse into the gate oxide layer 50. Moreover, after the gate oxide layer 50 undergoes the post-oxidation annealing process, nitrogen atoms in the silicon-rich nitride film 40 can more readily diffuse toward the interface, while the carbon atoms are less likely to react with oxygen atoms, thereby reducing the formation of carbon by-products and naturally decreasing the number of interface defects to improve interface quality.

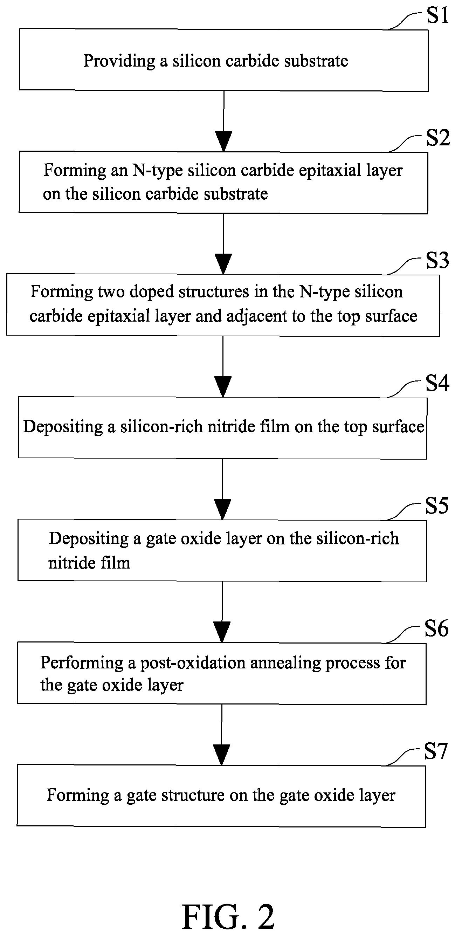

Please refer to both FIG. 1 and FIG. 2 below. FIG. 2 is a flowchart illustrating the manufacturing method of the silicon carbide metal-oxide-semiconductor field-effect transistor (MOSFET) of the present invention. As shown in FIGs. 1 and 2, the manufacturing method of the silicon carbide MOSFET according to the present invention includes the following steps:
Step S1: Providing a silicon carbide substrate.

First, the present invention provides a silicon carbide substrate 10 for carrying other structures or components of the silicon carbide MOSFET 1.

Step S2: Forming an N-type silicon carbide epitaxial layer on the silicon carbide substrate.

After the silicon carbide substrate 10 is provided in step S1, the present invention then performs chemical vapor deposition or related processes on the silicon carbide substrate 10 to form an N-type silicon carbide epitaxial layer 20 thereon. The silicon carbide substrate 10 and the N-type silicon carbide epitaxial layer 20 may serve as the base structure of the silicon carbide MOSFET 1 of the present invention. As shown in FIG. 1, the N-type silicon carbide epitaxial layer 20 includes a top surface 21, and the top surface 21 is located on the side of the N-type silicon carbide epitaxial layer 20 opposite to the side adjacent to the silicon carbide substrate 10.

Step S3: Forming two doped structures in the N-type silicon carbide epitaxial layer and adjacent to the top surface.

After the N-type silicon carbide epitaxial layer 20 is formed in step S2, the present invention proceeds with ion implantation or related processes on the N-type silicon carbide epitaxial layer 20 to form two doped structures 30 adjacent to the top surface 21 of the N-type silicon carbide epitaxial layer 20. As shown in FIG. 1, each doped structure 30 includes a P-type well 31, an N+ doped region 32, and a P+ doped region 33. The N+ doped region 32 is located in the P-type well 31, and the P+ doped region 33 is also located in the P-type well 31 and adjacent to the N+ doped region 32.

Step S4: Depositing a silicon-rich nitride film on the top surface.

After forming the two doped structures 30 in step S3, the present invention performs an atomic layer deposition process using silicon-rich nitride on the N-type silicon carbide epitaxial layer 20 to form a silicon-rich nitride film 40 on the top surface 21 of the N-type silicon carbide epitaxial layer 20. This film serves as an interfacial passivation layer between the N-type silicon carbide epitaxial layer 20 and the subsequently formed gate oxide layer 50.

Step S5: Depositing a gate oxide layer on the silicon-rich nitride film.

After the silicon-rich nitride film 40 is formed in step S4, the present invention proceeds with another deposition process to form a gate oxide layer 50 on the silicon-rich nitride film 40. The silicon-rich nitride film 40 serves to insulate the gate oxide layer 50 from the N-type silicon carbide epitaxial layer 20.

Step S6: Performing a post-oxidation annealing process for the gate oxide layer.

After forming the gate oxide layer 50 in step S5, the present invention performs a post-oxidation annealing process for the gate oxide layer 50 to reduce the interface state density. In one embodiment of the present invention, the post-oxidation annealing process involves placing the partially fabricated structure of the silicon carbide metal-oxide-semiconductor field-effect transistor 1 in an environment containing nitric oxide (NO) or nitrous oxide (N₂O) for high-temperature annealing.

Step S7: Forming a gate structure on the gate oxide layer.

After the post-oxidation annealing process is performed in step S6, the present invention proceeds with a related process on the gate oxide layer 50 to form a gate structure 60 on the gate oxide layer 50.

Accordingly, by applying the manufacturing method of the silicon carbide metal-oxide-semiconductor field-effect transistor of the present invention, the silicon carbide metal-oxide-semiconductor field-effect transistor 1 of the present invention can be fabricated.

As described above, the silicon carbide metal-oxide-semiconductor field-effect transistor 1 of the present invention can effectively improve the interface quality between the gate oxide layer 50 and the N-type silicon carbide epitaxial layer 20 by providing the silicon-rich nitride film 40, thereby increasing the channel mobility and reducing the channel resistance and on-resistance. Therefore, the silicon carbide metal-oxide-semiconductor field-effect transistor 1 of the present invention not only reduces the power loss of the device but also provides stable reliability.

The above-described embodiments are essentially for illustrative purposes only and are not intended to limit the embodiments of the claimed subject matter or their applications or uses. Moreover, although at least one exemplary embodiment has been presented in the foregoing description, it should be understood that numerous modifications may still be made to the present invention. It should likewise be understood that the embodiments described herein are not intended to limit the scope, use, or configuration of the claimed subject matter in any way. On the contrary, the foregoing embodiments provide a convenient guide for those of ordinary skill in the art to implement one or more embodiments described herein. Furthermore, various modifications in function and arrangement of components may be made without departing from the scope defined by the appended claims, which encompass known equivalents as well as all foreseeable equivalents at the time of filing this patent application.

## Claims

1. A method for manufacturing a silicon carbide metal-oxide-semiconductor field-effect transistor, comprising the steps of:
providing a silicon carbide substrate;
forming an N-type silicon carbide epitaxial layer on the silicon carbide substrate, wherein the N-type silicon carbide epitaxial layer includes a top surface;
forming two doped structures in the N-type silicon carbide epitaxial layer adjacent to the top surface, wherein each of the doped structures includes a P-type well, an N+ doped region, and a P+ doped region, the N+ doped region is located in the P-type well, and the P+ doped region is located in the P-type well and adjacent to the N+ doped region;
depositing a silicon-rich nitride film on the top surface;
depositing a gate oxide layer on the silicon-rich nitride film, wherein the silicon-rich nitride film insulates the gate oxide layer from the N-type silicon carbide epitaxial layer;
performing a post-oxidation annealing process for the gate oxide layer; and
forming a gate structure on the gate oxide layer.

2. The method for manufacturing a silicon carbide metal-oxide-semiconductor field-effect transistor according to Claim 1, wherein the thickness of the silicon-rich nitride film is between 50Å and 150Å.

3. The method for manufacturing a silicon carbide metal-oxide-semiconductor field-effect transistor according to any of the previous Claims, wherein the silicon-rich nitride film is deposited on the top surface by an atomic layer deposition process.

4. The method for manufacturing a silicon carbide metal-oxide-semiconductor field-effect transistor according to any of the previous Claims, wherein the post-oxide annealing process is performed in an environment containing nitric oxide or nitrous oxide for high-temperature annealing.

5. The method for manufacturing a silicon carbide metal-oxide-semiconductor field-effect transistor according to any of the previous Claims, wherein the gate structure is made of polysilicon or metal.

6. A silicon carbide metal-oxide-semiconductor field-effect transistor, comprising:
a silicon carbide substrate;
an N-type silicon carbide epitaxial layer, formed on the silicon carbide substrate and including a top surface;
two doped structures, formed in the N-type silicon carbide epitaxial layer adjacent to the top surface, wherein each of the doped structures includes a P-type well, an N+ doped region, and a P+ doped region, the N+ doped region is located in the P-type well, and the P+ doped region is located in the P-type well and adjacent to the N+ doped region;
a silicon-rich nitride film, located on the top surface;
a gate oxide layer, located on the silicon-rich nitride film, wherein the silicon-rich nitride film insulates the gate oxide layer from the N-type silicon carbide epitaxial layer; and
a gate structure, located on the gate oxide layer.

7. The silicon carbide metal-oxide-semiconductor field-effect transistor according to Claim 6, wherein the thickness of the silicon-rich nitride film is between 50Å and 150Å.

8. The silicon carbide metal-oxide-semiconductor field-effect transistor according to Claims 6 or 7, wherein the silicon-rich nitride film is deposited on the top surface by an atomic layer deposition process.

9. The silicon carbide metal-oxide-semiconductor field-effect transistor according to any of the previous Claims 6 to 8, wherein the gate oxide layer is processed by a post-oxide annealing process, and the post-oxide annealing process is performed in an environment containing nitric oxide or nitrous oxide for high-temperature annealing.

10. The silicon carbide metal-oxide-semiconductor field-effect transistor according to any of the previous Claims 6 to 9, wherein the gate structure is made of polysilicon or metal.
